# DEMANDE DE BREVET EUROPEEN

(11) **EP 4 645 583 A1**
(43) Date de publication de la demande: **05.11.2025**
(21) Numéro de dépôt: 25172883.8
(22) Date de dépôt: 28.04.2025
(51) Int. Cl.: H01P 5/12, H01P 5/08, H01P 5/107

(54) **COMPOSANT DIVISEUR / COMBINEUR DE PUISSANCE DU TYPE GUIDE COAXIAL EN TECHNOLOGIE SIW**

(30) Priorité: 29.04.2024 FR 2404450
(71) Demandeur: THALES, 92190 Meudon (FR)
(72) Inventeur: DENIS, Stéphane, 35370 Étrelles (FR); THORINIUS, Audrey, 35370 Étrelles (FR); BILLAND, Laurent, 35370 Étrelles (FR); TANGUY, Anne-Catherine, 35370 Étrelles (FR)
(74) Mandataire: Lavoix

(57) **Abrégé**

La présente invention concerne un composant diviseur / combineur de puissance du type guide coaxial, caractérisé en ce qu'il est réalisé en technologie « guide d'onde intégré au substrat », dans une carte de circuit intégré muticouche, qui comporte un empilement d'une pluralité de couches conductrices (21, 22, 23, 24, 25, 26 27) séparées les unes des autres par des couches isolantes.

## Description

La présente invention a pour domaine celui des composants diviseurs et/ou combineurs de puissance du type guide coaxial.

Un composant diviseur / combineur de puissance se doit de présenter une large bande de fréquence de fonctionnement, c'est-à-dire une bande sur laquelle ses caractéristiques restent sensiblement constantes. Notamment le composant présente des pertes faibles. Il présente des ondulations faibles, c'est-à-dire des variations de pertes en transmission faibles.

Les solutions classiques, fondées sur des lignes de transmission gravée sur une couche conductrice d'une carte de circuits imprimés - PCB (pour « printed circuit board ») induisent des pertes de puissance trop importantes. En conséquence, il est nécessaire d'utiliser des solutions alternatives, notamment les diviseurs / combineurs spatiaux.

Un diviseur / combineur spatial est basé sur un guide d'onde (guide sans âme) ou un guide coaxial (guide avec âme).

A ce jour, les diviseurs / combineurs spatiaux constituent une solution efficace en terme de puissance radiofréquence - RF admissible et de pertes faibles.

Cependant, comme présenté par exemple dans le document US7215220B1, les diviseurs / combineurs spatiaux sont constitués de multiples sous-ensembles de pièces mécaniques complexes et de substrats radiofréquence - RF, qui les rendent volumineux, lourds et onéreux. Les interconnexions avec les éléments actifs sont complexes à réaliser.

De plus, l'ensemble est mal approprié à une réalisation suivant un procédé automatique et nécessite de nombreuses opérations manuelles, mal adaptées à une production de masse et/ou à faible coût.

Par ailleurs, lorsqu'ils sont constitués d'un guide coaxial (de section cylindrique ou rectangulaire), ce dernier est souvent surdimensionné et donc susceptible de présenter des dégradations de performances, notamment des variations de transmission, en fonction des défauts de symétries internes (liés à leur fabrication) ou externes (liés aux éléments connectés sur leurs voies). Les transformations d'impédances, réalisées au moyen de lignes antipodales, présentent des fréquences de coupure basse qui limitent significativement la bande passante de tels composants diviseur / combineur de puissance.

Le but de l'invention est alors de répondre à ces problèmes en proposant un nouveau type de composants diviseurs/combineurs de puissance.

A cet effet, l'invention a pour objet un composant diviseur / combineur de puissance du type guide coaxial, caractérisé en ce qu'il est réalisé en technologie « guide d'onde intégré au substrat », dans une carte de circuit intégré muticouche, qui comporte un empilement d'une pluralité de couches conductrices séparées les unes des autres par des couches isolantes.

Suivant d'autres aspects avantageux de l'invention, le composant comprend une ou plusieurs des caractéristiques suivantes, prises isolément ou suivant toutes les combinaisons techniquement possibles :
- le guide coaxial comporte un conducteur externe et un conducteur interne, le conducteur externe étant porté à un potentiel de masse, le conducteur interne circulant à l'intérieur du conducteur externe et reliant un premier port du composant à chaque second port d'une pluralité de seconds ports du composant.
- le conducteur externe comporte au moins un plan de masse supérieur, délimité dans une couche conductrice supérieure du circuit intégré multicouche, un plan de masse inférieur, délimité dans une couche conductrice inférieure du circuit intégré multicouche, et une pluralité de vias métallisées latéraux reliant électriquement les plans de masse supérieur et inférieur.
- le composant comportant successivement, le long d'un axe longitudinal : une section d'entrée de transformation d'impédance, sur laquelle le conducteur interne comporte une piste commune connectée au premier port ; une section de sortie de séparation des voies, sur laquelle le conducteur interne comporte une pluralité de pistes dérivées ; et, une section intermédiaire de subdivision en plusieurs voies, sur laquelle le conducteur interne comporte une pluralité de pistes intermédiaires, qui sont superposées selon une épaisseur du circuit intégré multicouche et connectées entre elles par des vias, la pluralité de pistes intermédiaire comportant au moins une piste intermédiaire centrale connectée à la piste commune de la section d'entrée, et au moins une piste intermédiaire de subdivision présentant une pluralité de branches, chaque branche étant connectée à une piste dérivée de la section de sortie.
- la piste commune présente un ou plusieurs étage(s) de transformation d'impédance, la largeur de la piste commune allant en s'élargissant entre les deux extrémités d'un étage de transformation d'impédance.
- la piste centrale présente des premier et second étages de transformation d'impédance disposés successivement, une première paire de premiers plans de masse disposés de part et d'autre de la piste centrale étant associée au premier étage et une seconde paire de seconds plans de masse disposés de part et d'autre de la piste centrale étant associée au second étage, les premiers plans de masse recouvrant les premier et second étages, les seconds plans de masse recouvrant les second étages uniquement, les seconds plans de masse étant plus proches de la couche centrale que les premiers plans de masse.
- chaque piste dérivée comporte au moins un tronçon allant en s'élargissant de manière à ajuster une impédance du guide d'onde sur la section de sortie.
- la section intermédiaire constitue un diviseur/combineur spatial.
- la section intermédiaire comporte une pluralité de premières pistes intermédiaires portées par autant de couches différentes du circuit multicouche, chaque première piste intermédiaire comportant une pluralité de branches, chaque branche de la section intermédiaire étant connectée à une piste dérivée correspondante parmi les pistes dérivées de la section de sortie.
- la section intermédiaire comporte une pluralité de secondes pistes intermédiaires, chaque seconde piste intermédiaire comportant une pluralité de branches, qui ne sont pas connectées, chaque seconde piste intermédiaire comportant au moins une portion de subdivision disposée au droit d'au moins une portion de subdivision d'une première piste intermédiaire.
- la section de sortie comporte un plan de masse intermédiaire entre les pistes dérivées connectées aux branches d'une première piste intermédiaire et les pistes dérivées connectées aux branches d'une autre première piste intermédiaire.
- la pluralité de seconds ports forme une matrice sur une pluralité de N niveaux, chaque niveau correspondant à un couche différente du circuit multicouche, chaque niveau comportant M seconds ports.

L'invention apparaîtra plus clairement à la lecture de la description qui va suivre, donnée uniquement à titre d'exemple non limitatif, et faite en référence aux dessins dans lesquels :
- la figure 1 est une représentation schématique d'un dispositif d'amplification de puissance en vue de dessus, intégrant deux composants en technologie SIW selon l'invention, le premier fonctionnant en tant de diviseur de puissance et le second en tant que combineur de puissance ;
- la figure 2 est une représentation schématique en vue de dessus d'un mode de réalisation du composant diviseur de puissance de la figure 1 ;
- la figure 3 représente différentes sections transversales du composant de la figure 2 ; et,
- la figure 4 est une représentation schématique en perspective éclatée d'une section de subdivision du composant de la figure 2.

Le composant diviseur / combineur de puissance selon l'invention est un composant diviseur / combineur de puissance du type guide coaxial réalisé en technologie SIW.

La technologie « guide d'onde intégré au substrat » - SIW (pour « substrate integrated waveguide » en anglais) permet de réaliser le composant dans l'épaisseur d'un carte de circuit imprimé multicouche.

La technologie SIW permet de répondre à l'ensemble des performances techniques et des contraintes industrielles. Cette solution permet d'améliorer l'encombrement, le coût et le poids du composant, pour des performances RF à mi-chemin entre celles obtenues pour les diviseurs / combineurs spatiaux mécaniques et celles obtenues pour des diviseurs / combineurs classiques.

Dans ce qui suit, sera plus particulièrement présenté le cas d'un composant diviseur de puissance, c'est-à-dire un composant utilisé en diviseur de puissance, tout en gardant à l'esprit qu'il s'agit tout aussi bien d'un composant combineur de puissance, c'est-à-dire le même composant mais utilisé en combineur de puissance. Cela dépend en fait de la manière dont ce composant est intégré au montage électrique réalisé sur la carte.

La manière de réaliser un diviseur de puissance en technologie SIW porte principalement sur la manière de réaliser la subdivision des voies, tout en assurant de hautes performances sur une large bande passant, ces hautes performances se caractérisant en particulier en termes d'ondulation de la transmission des signaux RF et de faibles pertes d'insertion.

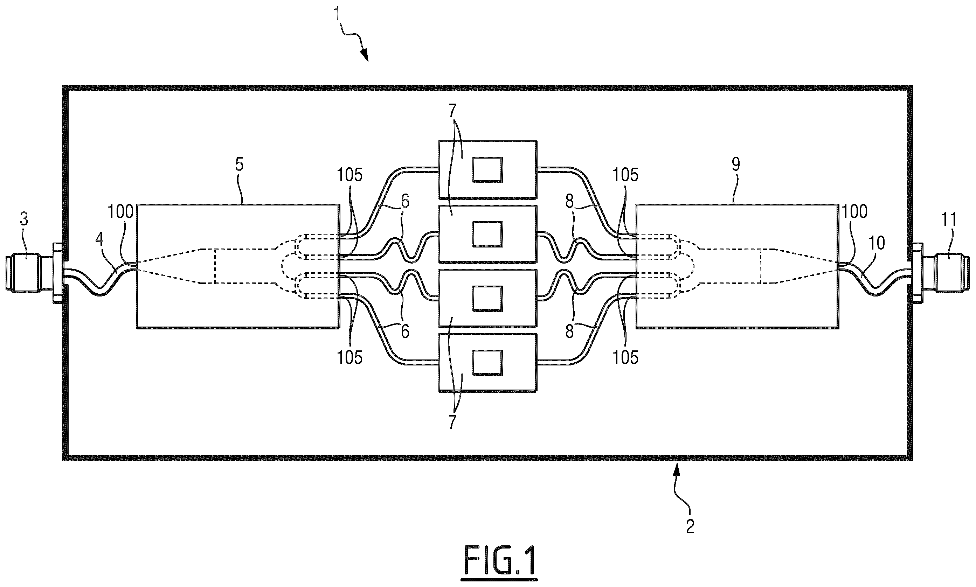

La figure 1 est une représentation schématique d'un dispositif d'amplification de puissance en vue de dessus.

Le dispositif d'amplification 1 est un circuit électronique réalisé sur une carte de circuit imprimé - PCB (« Printed circuit board ») multicouche, ou carte PCB 2.

La carte PCB 2 résulte de l'empilement d'une pluralité de couches conductrice, en cuivre, deux couches successives étant séparées par une couche isolante, en un matériau diélectrique.

La carte PCB 2 porte :
- un connecteur d'entrée 3, connectée à une électronique de génération d'un signal à amplifier (l'électronique de génération n'est pas représentée sur la figure).
- un banc de NxM amplificateurs de puissance, référencés par le chiffre 7 sur la figure 1, où N est un entier strictement supérieur à l'unité et M est un entier de préférence supérieur à l'unité. Dans le présent mode de réalisation, M est égal à deux et N est égal à quatre. Ainsi, quatre amplificateurs 7 sont montés sur la face supérieure de la carte PCB 2 (et par conséquent visibles sur la figure 1) et quatre amplificateurs sont montés sur la face inférieure de la carte PCB 2 (et par conséquent non représentés sur la figure 1).
- un connecteur de sortie 11, pour transmettre le signal amplifié, par exemple, à un élément rayonnant d'une antenne.

La carte PCB 2 intègre un composant selon l'invention utilisé en diviseur de puissance :
Ce composant 5 comporte un premier port 100 connecté, par une ligne micro ruban 4 gravée dans la carte PCB 2, au connecteur d'entrée 3.

Le composant 5 comporte une pluralité de seconds ports 105, chaque second port étant connecté, par une ligne micro ruban 6 gravée dans la carte PCB 2, à un amplificateur 7 particulier du banc d'amplificateurs.

La carte PCB 2 intègre un composant selon l'invention utilisé en combineur de puissance :
Ce composant 9 comporte une pluralité de second ports 105, chaque port 105 étant connecté, par une ligne micro ruban 8 gravée dans la carte PCB 2, à un amplificateur 7 particulier du banc d'amplificateurs.

Le composant 9 comporte un premier port 100 connecté, par une ligne micro ruban 10 gravée dans la carte PCB 2, au connecteur de sortie 11.

Le composant diviseur de puissance 5 et le composant combineur de puissance 9 sont identiques. Ils sont montés tête-bêche dans le circuit du dispositif 1.

Dans ce qui suit, sera plus particulièrement décrit le composant 5, mais une description similaire pourrait être faite pour le composant 9.

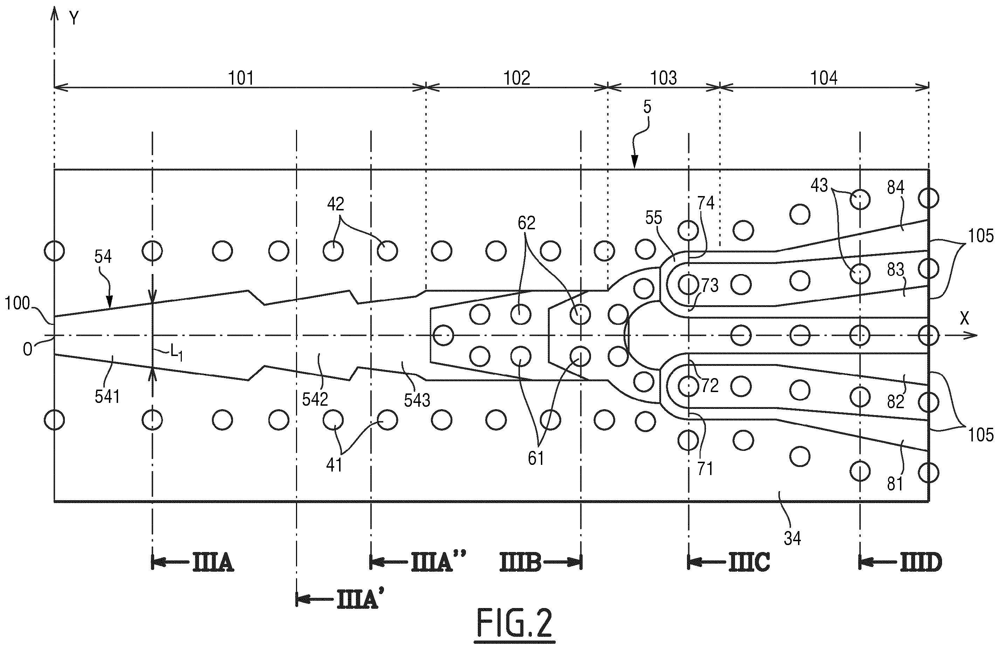

Un mode de réalisation préféré d'un composant diviseur de puissance en technologie SIW va maintenant être présenté en référence aux figures 2 à 4.

La figure 2 est une représentation schématique du composant diviseur de puissance 5 en vue de dessus, les plans de masse des différentes couches étant omis pour gagner en lisibilité. La figure 2 représente donc les pistes des couches conductrices internes constitutives de l'âme du guide coaxial du composant 5.

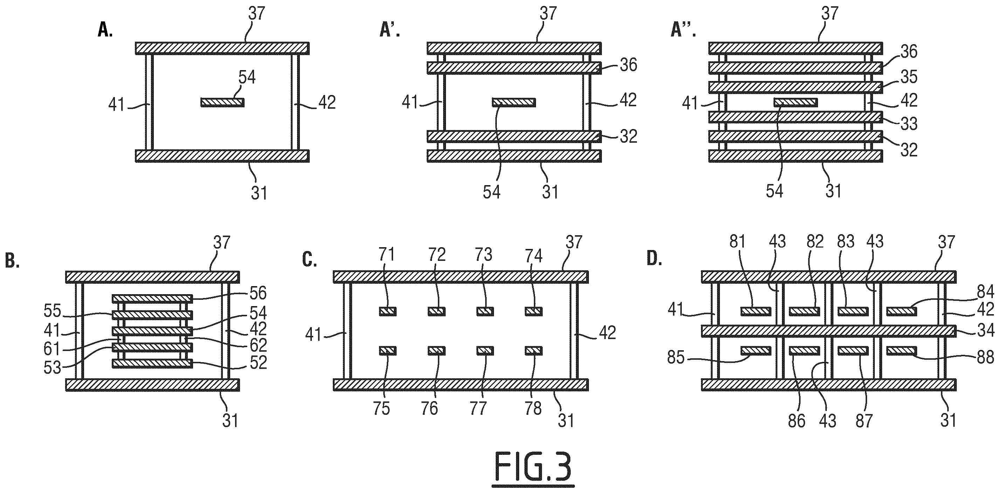

Différentes coupes du composant 5 par des plans transversaux sont représentées sur la figure 3.

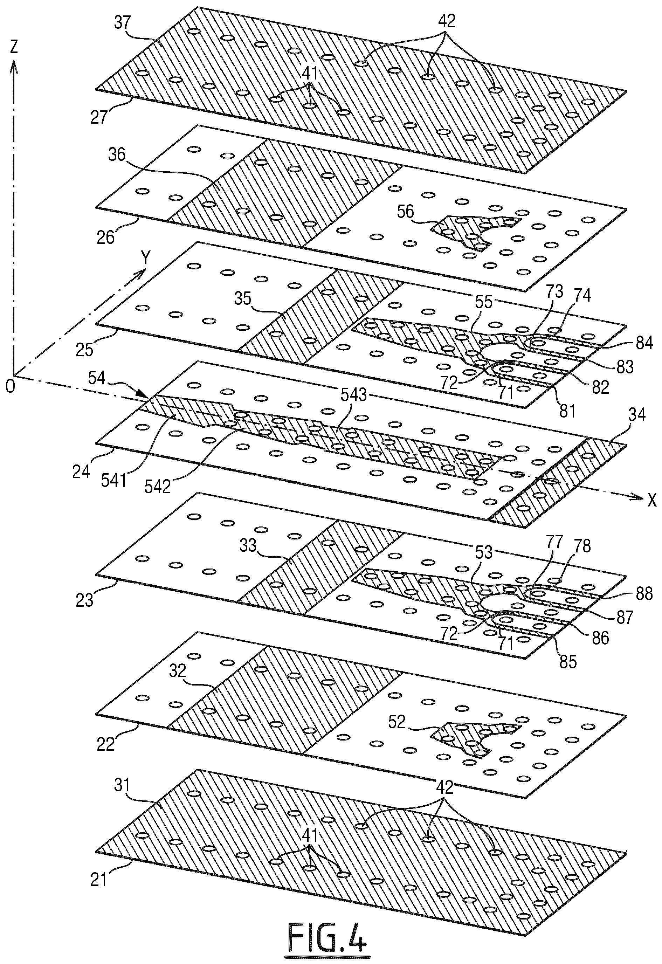

Enfin, la figure 4 est une représentation en perspective du composant 5.

Le composant 5 est un diviseur spatial, plus spécifiquement un diviseur spatial du type guide coaxial.

Le composant 5 est réalisé dans l'épaisseur de la carte PCB 2.

Dans le présent mode de réalisation, la carte PCB 2 résulte de l'empilement, selon un axe Z, de sept couches conductrices 21 à 27, chaque couche conductrice étant isolée de la précédente par une couche isolante. Plus spécifiquement, comme illustré sur la figure 4, la carte PCB 2 comporte :
- une couche externe inférieure 21.
- une couche externe supérieure 27.
- une couche interne centrale 24.
- entre la couche externe inférieure 21 et la couche interne centrale 24, une seconde couche interne intermédiaire inférieure 22 et une première couche interne intermédiaire inférieure 23.
- de manière symétrique, entre la couche interne centrale 24 et la couche externe supérieure 27, une première couche interne intermédiaire supérieure 25 et une seconde couche interne intermédiaire supérieure 26.

Une couche conductrice est gravée de manière à délimiter des pistes (qui peuvent être des plans, notamment des plans de masse).

Les pistes de deux (ou plus) couches conductrices de la carte PCB 2 peuvent être connectées électriquement par un ou plusieurs vias métallisés circulant selon l'épaisseur du PCB 2.

Un repère orthonormé XYZ est attaché à un point d'origine O, qui est situé sur la couche intermédiaire 24, au niveau du premier port 100, constituant le port d'entrée du composant fonctionnant en diviseur de puissance.

L'axe Z est l'axe d'empilement des couches de la carte PCB 2.

L'axe X constitue l'axe longitudinal du composant 5 depuis le port 100 jusqu'aux seconds ports 105, constituant les ports de sorties du composant fonctionnant en diviseur de puissance.

L'axe Y est l'axe transversal.

Ainsi, le plan de la couche interne centrale 24 repose dans le plan XY.

Dans le présent mode de réalisation, le composant 5 est symétrique par rapport au plan XZ et au plan XY.

Comme illustré sur la figure 2, le composant 5 peut être subdivisé selon l'axe X en sections successives.

La première section 101 présente une structure SIW similaire à celle d'une ligne de transmission classique triplaque (« stripline »).

Plus précisément, comme illustré sur la coupe A de la figure 3, le composant 5 présente une piste formant plan de masse supérieur 37, délimitée dans la couche conductrice externe supérieure 27, et une piste formant plan de masse inférieur 31, délimitée dans la couche externe inférieure 21.

Les plans de masse supérieur 37 et inférieur 31 sont connectés par des rangées de vias latéraux 41 et 42.

L'ensemble formé par les deux plans de masse 37 et 31 et les vias latéraux 41 et 42 constitue le conducteur externe, ou blindage, de la ligne triplaque.

Le conducteur interne, ou âme, de la ligne triplaque est une ligne dite « commune ».

La ligne commune est, dans le présent mode de réalisation, faite d'une piste centrale 54, délimitée dans la couche interne centrale 24.

La couche interne centrale 24 est reliée électriquement au port d'entrée 100 du composant 5, et par conséquent au connecteur d'entrée 3 pour recevoir le signal à amplifier.

La piste centrale 54 présente une largeur L1 et une épaisseur E1.

La piste centrale présente une épaisseur faible et, à ce titre, la première section 101 correspond à une ligne triplaque plutôt qu'à un guide coaxial.

La piste centrale 54 est conformée pour réaliser une fonction de transformation d'impédance.

La largeur de la piste centrale 54 s'élargie progressivement lorsque l'on se déplace le long de l'axe X.

Sachant qu'en un point le long de l'axe X, la valeur de la largeur d'une piste définit l'impédance de cette piste en ce point, l'élargissement de la piste centrale 54 permet une diminution de l'impédance.

L'impédance de la piste centrale 54 au niveau de son extrémité proximale, i.e. d'entrée de la première section 101, est choisie par configuration du composant 5 égale par exemple à une impédance nominale usuelle, ou standard, de 50 ohms.

L'impédance de la piste centrale 54 au niveau de son extrémité distale, i.e. de sortie de la première section 101 est choisie par configuration du composant 5 égale par exemple à 30 Ohms.

Avantageusement, pour réaliser une forte diminution de l'impédance entre les extrémités de la piste 54 sans que cela ne conduise à une piste ayant une largeur trop importante, la piste centrale 54 est conformée en dents de scie de manière à présenter trois étages de transformation d'impédance successifs. La transition entre deux étages successifs est associée à l'introduction d'une paire de plans de masse.

Ainsi le première étage 541 est située entre les plans de masse 31 et 37 des couches 21 et 37 (comme illustré sur la coupe A de la figure 3), le second étage 542 est située, en outre, entre les plans de masses 32 et 36 réservés dans les couches 22 et 26 (comme illustré sur la coupe A' de la figure 3), et le troisième étage 543 est située, en outre, entre les plans de masses 33 et 35, réservés dans les couches 23 et 25 (comme illustré sur la coupe A" de la figure 3).

Le guide d'onde n'a qu'une piste centrale, qui forme l'âme au centre de la structure, des plans de masse, qui forment le blindage et que se rapprochent progressivement de la piste centrale.

L'avantage cette structure étagée est de transformer une impédance standard, typiquement 50 Ohms, en une impédance basse, typiquement moins de 10 Ohms, sur une large bande de fréquence et avec une minimum de pertes RF et, de manière corrélée, avec une tenue en puissance maximale.

La section médiane du composant 5, dite de subdivision des voies, regroupe une seconde section 102 et une troisième section 103.

Les plans de masse des couches intermédiaires qui s'étaient rapprochés de l'âme progressivement dans la section 101 disparaissent au niveau de la transition avec la section 102.

La seconde section 102 présente une structure SIW similaire à celle d'un guide coaxial de section rectangulaire de basse impédance. L'âme s'épaissis selon la direction Z progressivement dans la section 102.

Plus précisément, comme illustré sur la coupe B de la figure 3, on retrouve le conducteur externe, qui est constitué des plans de masse supérieur et inférieur, 31 et 37, et des vias latéraux 41 et 42 connectant électriquement ces plans de masse.

Le conducteur interne est maintenant constitué d'une ligne dite « de subdivision ». Celle-ci est constituée d'une pluralité de pistes internes 52 à 56 superposées les unes au-dessus des autres, respectivement gravées dans les couches conductrices internes 22 à 26.

Les pistes internes sont connectées électriquement les unes aux autres par des vias centraux, par exemple répartis en deux rangs, 61 et 62.

Le conducteur interne présentant maintenant une épaisseur élevée, on peut parler de guide d'onde pour la seconde section 102.

La piste centrale 54 de la seconde section 102 constitue la continuité de la piste centrale 54 de la première section 101.

Les pistes 52, 53, 55 et 56 sont donc portées au potentiel de la piste centrale 54 par les vias 61 et 62.

Avantageusement, les pistes internes peuvent présenter une largeur qui évolue le long de l'axe X de manière à munir la seconde section 102 d'une fonction de transformation d'impédance, en l'occurrence de diminution d'impédance, de manière à présenter, au niveau de l'extrémité de sortie de la seconde section, une très basse impédance, par exemple de 10 Ohms.

La troisième section 103 présente une structure SIW de séparation des voies en tant que telle. Elle présente NxM sorties.

Plus précisément, comme illustré sur la section C de la figure 3, on retrouve le conducteur externe du guide coaxial constitué des plans de masse supérieur 37 et inférieur 31 et des vias latéraux 41 et 42.

Le conducteur interne du guide coaxial comporte des pistes dites premières pistes internes inférieure et supérieure, 53 et 55, respectivement portées par les premières couches conductrices internes inférieure et supérieure, 23 et 25.

Par exemple, la première piste interne supérieure 55 se subdivise, dans une zone de subdivision, en une pluralité de quatre branches, respectivement 71 à 74 et la première piste interne inférieure 53 se subdivise en une pluralité de quatre branches, respectivement 75 à 78.

L'extrémité distale de chacune de ces branches constituent la sortie de la section de subdivision des voies.

De préférence, le conducteur interne du guide coaxial comporte également des pistes dites secondes pistes internes supérieure et inférieure, 52 et 56, respectivement portées par les secondes couches conductrices internes inférieure et supérieure, 22 et 26.

Les secondes pistes internes 52 et 56 s'interrompent sensiblement à l'aplomb des zones de subdivision des premières pistes internes 53 et 55. Elles ont un rôle capacitif pour améliorer le transfert de puissance.

Le principe de la section de séparation des voies est ainsi celui des diviseurs/combineurs spatiaux, c'est-à-dire que les champs du mode propagé par le conducteur interne du guide coaxial sont subdivisés dans l'espace en NxM modes approchants (pour assurer une transition la plus douce possible (« smooth » en anglais). Ici M représente le nombre de niveaux, c'est-à-dire de premières pistes internes, et N représente le nombre de branches de chaque première piste interne.

La section de subdivision des voies est conçue pour assurer une répartition optimale (typiquement une répartition égale des puissances et des impédances) vers les lignes dérivées hautes impédances constitutives de la quatrième section 104 du composant 5.

Le conducteur interne présente, en amont de la subdivision, une section suffisante de manière à permettre une transition efficace vers les MxN lignes dérivées hautes impédances.

A contrario, la section de chacune des branches de la subdivision est suffisamment réduite de façon à minimiser l'influence des modes de propagation parasites.

L'emplacement des vias de masse dans la zone de transition est sensible et doit être ajusté.

La quatrième section 104 présente une structure SIW similaire à celle d'une pluralité de lignes de transmission triplaques cheminant parallèlement.

Elle réalise une fonction d'éloignement de chacune des lignes dérivées situées dans le prolongement de chacune des branches de la troisième section 103.

Elle réalise avantageusement également une fonction de transformation d'impédance.

Plus précisément, comme illustré sur la section D de la figure 3, en plus des plans de masse supérieur et inférieur, un demi plan de masse intermédiaire 34 est délimité dans la couche conductrice centrale 24. Ces trois plans de masse sont connectés par des rangées de vias, non seulement des rangs de vias latéraux 41 et 42 mais également des rangs de vias intermédiaires 43.

Les pistes délimitées dans les premières couches internes supérieure et inférieure, qui constituent autant de lignes dérivées haute impédance, sont maintenant isolées les unes des autres.

Ainsi, une matrice de NxM de lignes triplaques (ou guides coaxiaux par abus de langage) est formée. Dans le présent mode de réalisation, on a quatre lignes triplaques par niveau et deux niveaux dans l'épaisseur de la carte PCB 2.

L'élargissement de la largeur d'une ligne dérivée formant l'âme d'une ligne triplaque entre l'entrée et la sortie de la quatrième section 104 permet de réduire l'impédance.

L'impédance est par exemple abaissée de 80 Ohms en entrée à 50 Ohms en sortie.

La distance entre les vias latéraux est augmentée pour permettre la séparation spatiale des différentes voies.

La figure 4 est une représentation en perspective éclatée du composant 5.

Seules les couches conductrices sont représentées sur cette figures, et les pistes ou plan de masse délimités dans ces couches après gravure sont représentés avec des hachures.

On retrouve les plans de masse supérieur et inférieur 31 et 37 connectés par des vias latéraux, 41 et 42. Il est à noter que sur la figure 4, seul l'intersection d'un via avec une couche conductrice est représentée.

Dans la couche centrale 24, la piste centrale 54 se prolonge jusqu'à une extrémité distale sensiblement rectangulaire.

Au droit de la transition entre le premier et le second étages, 541 et 542 de la piste centrale 54, débute les plans de masses 32 et 36.

Au droit de la transition entre le second et le troisième étages, 542 et 543 de la piste centrale 54, débute les plans de masses 33 et 35.

Les plans de masses 32, 33, 35 et 36 s'interrompent au droit de la fin du troisième étage 543, i.e. entre les première et seconde sections 101 et 102 du composant 5.

La première piste interne intermédiaire supérieure 55 (respectivement inférieure 53), qui est connectée électriquement à la piste centrale 54 par des vias centraux, 61, 62, présente une extrémité proximale trapézoïdale.

Elle circule de manière rectiligne le long de l'axe longitudinal X.

Au niveau de la troisième section 103, elle se subdivise d'abord en deux branches, puis chaque branche se subdivise à son tour en deux nouvelles branches. Les quatre branches 71 à 74 (respectivement 75 à 78) sont connectées aux quatre lignes dérivées 81 à 84 (respectivement 85 à 88).

La géométrie de chaque subdivision est optimisée pour transmettre la puissance aux lignes dérivées le plus graduellement possible.

En sortie de la troisième section 103, un plan de masse intermédiaire 34, réservé dans la couche centrale 24, permet d'isoler les lignes dérivées des deux niveaux différents.

Des vias 43 entre les plans de masse permet d'isoler les lignes dérivées d'un même niveau.

La seconde piste interne supérieure 56 (respectivement inférieure 52), qui est connectée électriquement à la piste centrale 54 et aux première pistes internes 53 et 55 par des vias centraux, 61, 62, s'étend entre une extrémité proximale, trapézoïdale, et une paire d'extrémités distales, sensiblement rectangulaires, résultant d'une subdivision en deux prolongements du corps de la seconde piste interne.

La portion de subdivision d'une seconde piste interne se situe essentiellement au droit de la première portion de subdivision des premières pistes internes supérieure et inférieure et de l'extrémité distale de la piste centrale 54.

Ses prolongements sont reliés par des vias aux premières pistes internes supérieure et inférieure.

Ces prolongements constituent des renforts capacitifs ajustables.

La forme de la portion de subdivision des pistes internes 52 et 56 (largeur et longueur des embranchements/ramifications) est ajustée pour optimiser l'adaptation des impédances présentes de part et d'autre de l'interface entre les troisième et quatrième sections 103 et 104 du composant 5.

Le composant selon l'invention peut être réalisé de différentes façons :
De manière générale, le compostant présente NxM voies, réparties sur M niveaux ou couches du PCB et, sur chaque niveau, en N lignes dérivées.

La section de subdivision peut être réalisée selon différentes géométries pour créer plus ou moins de voies : par exemple, pour générer seulement quatre voies, il est possible de ne pas procéder à la seconde subdivision ; par exemple encore, pour créer seize voies, il est possible de procéder à un troisième ordre de subdivision ; dans encore un autre exemple, pour créer un autre nombre de voies par niveau, il est possible de créer des subdivisions par trois branches plutôt que par deux branches.

Cette structure, adaptée pour fonctionner avant tout en diviseur, peut également fonctionner, en sens inverse, en combineur de puissance sur des signaux similaires (en spectre, phase et amplitude). La recombinaison des ondes portées par les NxM lignes dérivées vers la ligne commune est également optimale.

Avantageusement d'autres plans de masse peuvent être prévus pour renforcer l'isolement de l'âme centrale du guide coaxial. Notamment, la couche conductrice centrale 24 comporte, de part et d'autre de la piste centrale 54, et à distance des bords de celle-ci, deux demi-plans de masse latéraux. Ils sont connectés aux plans de masse supérieur et inférieur par les vias latéraux.

La solution présentée ci-dessus permet de maitriser les ondulations sur une large bande passante, les disparités de phase, de puissance et d'adaptation d'impédance, en particulier de minimiser la présence et l'excitation de modes parasites.

Avantageusement la forme de la zone de subdivision résulte d'une simulations électromagnétique tridimensionnelle pour assurer le meilleur compromis entre tenue en puissance, faibles pertes et large bande passante.

En ce qui concerne les couches isolantes de la carte PCB, des substrats de diverses permittivités et/ou épaisseur peuvent être utilisés simultanément. De préférence, les substrats de plus haute permittivité sont situés à proximité des plans de masse.

A la place d'un assemblage mécanique, le composant selon invention est réalisée en technologie SIW, plus économique, plus léger et présentant un encombrement réduit.

Etant compact, le composant selon l'invention réduit le risque de porter de multiples modes de transmission, lesquels sont sources de dégradation de performances, notamment en haute fréquence.

A la place d'une structure qui sépare les voies avec des interfaces du type fente, puis des transitions vers des lignes micro-rubans, appelées ligne antipodales, le composant selon l'invention utilise des subdivisions de pistes (ou lignes rubans) d'impédances adaptées, combinées avec des transformateurs d'impédance. Le composant selon l'invention présente une fréquence de coupure particulièrement basse, car elle n'est pas contrainte par le court-circuit qu'impose la mise en œuvre de lignes antipodales.

Ainsi, le composant selon l'invention se caractérise par une large bande passante.

Le composant selon l'invention trouve des applications multiples en amplification de puissance, comme élément de formation des voies sur des antennes actives large bande à balayage électronique, en particulier pour des antennes embarquées.

## Revendications

1. Composant (5) diviseur / combineur de puissance comportant une carte de circuit intégré muticouche (2) et un guide coaxial réalisé en technologie « guide d'onde intégré au substrat », la carte de circuit intégré multicouche comportant un empilement d'une pluralité de couches conductrices séparées les unes des autres par des couches isolantes, le guide coaxial comportant un conducteur externe et un conducteur interne, le conducteur externe étant porté à un potentiel de masse, le conducteur interne circulant à l'intérieur du conducteur externe et reliant un premier port (100) du composant (5) à chaque second port (105) d'une pluralité de seconds ports du composant (5), lequel le conducteur externe comportant au moins un plan de masse supérieur (37), délimité dans une couche conductrice supérieure (27) du circuit intégré multicouche (2), un plan de masse inférieur (31), délimité dans une couche conductrice inférieure (21) du circuit intégré multicouche (2), et une pluralité de vias métallisées latéraux (41, 42) reliant électriquement les plans de masse supérieur et inférieur, le composant comportant successivement, le long d'un axe longitudinal :
- une section d'entrée (101) de transformation d'impédance, sur laquelle le conducteur interne comporte une piste commune (54) connectée au premier port (100) ;
- une section de sortie (104) de séparation des voies, sur laquelle le conducteur interne comporte une pluralité de pistes dérivées (81 à 88) ; et,
- une section intermédiaire (102, 103) de subdivision en plusieurs voies,
le composant étant **caractérisé en ce que**, sur la section intermédiaire, le conducteur interne comporte une pluralité de pistes intermédiaires (52 à 56), qui sont superposées selon une épaisseur du circuit intégré multicouche (2) et connectées entre elles par des vias, la pluralité de pistes intermédiaire comportant au moins une piste intermédiaire centrale (54) connectée à la piste commune de la section d'entrée, et au moins une piste intermédiaire de subdivision présentant une pluralité de branches, chaque branche étant connectée à une piste dérivée de la section de sortie, la section intermédiaire (102, 103) constituant un diviseur/combineur spatial.

2. Composant selon la revendication 1, dans lequel la piste commune (54) présente un ou plusieurs étage(s) de transformation d'impédance (541, 542, 543), la largeur de la piste commune allant en s'élargissant entre les deux extrémités d'un étage de transformation d'impédance.

3. Composant selon la revendication 2, dans lequel la piste centrale 54 présente des premier et second étages de transformation d'impédance (542, 543) disposés successivement, une première paire de premiers plans de masse (32, 36) disposés de part et d'autre de la piste centrale étant associée au premier étage et une seconde paire de seconds plans de masse (33, 35) disposés de part et d'autre de la piste centrale étant associée au second étage, les premiers plans de masse recouvrant les premier et second étages, les seconds plans de masse recouvrant les second étages uniquement, les seconds plans de masse étant plus proches de la couche centrale que les premiers plans de masse.

4. Composant selon l'une quelconque des revendications 1 à 3, dans lequel chaque piste dérivée (81 à 88) comporte au moins un tronçon allant en s'élargissant de manière à ajuster une impédance du guide d'onde sur la section de sortie.

5. Composant selon l'une quelconque des revendications 1 à 4, dans lequel la section intermédiaire (102, 103) comporte une pluralité de premières pistes intermédiaires (53, 55) portées par autant de couches différentes du circuit multicouche, chaque première piste intermédiaire comportant une pluralité de branches (71 à 74, 75 à 78), chaque branche de la section intermédiaire étant connectée à une piste dérivée correspondante parmi les pistes dérivées de la section de sortie (104).

6. Composant selon la revendication 5, dans lequel la section intermédiaire (102, 103) comporte une pluralité de secondes pistes intermédiaires (52, 56), chaque seconde piste intermédiaire comportant une pluralité de branches, qui ne sont pas connectées, chaque seconde piste intermédiaire comportant au moins une portion de subdivision disposée au droit d'au moins une portion de subdivision d'une première piste intermédiaire.

7. Composant selon l'une quelconque des revendications 5 à 6, dans lequel la section de sortie comporte un plan de masse intermédiaire entre les pistes dérivées connectées aux branches d'une première piste intermédiaire et les pistes dérivées connectées aux branches d'une autre première piste intermédiaire.

8. Composant selon l'une quelconque des revendications 1 à 7, dans lequel la pluralité de seconds ports (105) forme une matrice sur une pluralité de N niveaux, chaque niveau correspondant à un couche différente du circuit multicouche, chaque niveau comportant M seconds ports.
